Europäisches Patentamt

European Patent Office

Office européen des brevets

(11) Publication number: **0 276 130**
**A2**

## EUROPEAN PATENT APPLICATION

(21) Application number: 88300424.4

(22) Date of filing: 20.01.88

(51) Int. Cl.⁴: **H 03 D 7/00**
**H 03 G 1/00**

(30) Priority: **23.01.87 GB 8701495**

(43) Date of publication of application:
**27.07.88 Bulletin 88/30**

(84) Designated Contracting States: **CH FR GB LI**

(71) Applicant: **The General Electric Company, p.l.c.**
**1 Stanhope Gate**
**London W1A 1EH (GB)**

(72) Inventor: **Jones, Alan John**
**95 Lincoln Avenue**
**Clayton Newcastle-under-Lyme, ST5 3BA (GB)**

**Lakin, David Charles**
**Brooklyn City Lane**
**Longsdon Stoke-on-Trent Staffordshire (GB)**

(74) Representative: **Pope, Michael Bertram Wingate**
**Central Patent Department Wembley Office The General**
**Electric Company, p.l.c. Hirst Research Centre East Lane**
**Wembley Middlesex HA9 7PP (GB)**

(54) **Electrical signal mixer circuits.**

(57) An electric signal mixer circuit (1) of the switching type wherein the gain of the mixer is controlled by varying the duty cycle of the mixer's switching action. The mixer finds particular application in superheterodyne radio receivers incorporating automatic gain control to produce a constant amplitude output with a wider variation in amplitude of the received signals than can be compensated by control of the gains of the r.f. and i.f. amplification stages.

FIG. 1

EP 0 276 130 A2

**Description**

Electrical Signal Mixer Circuits

This invention relates to electrical signal mixer circuits.

Such circuits find many applications in electrical apparatus, especially in radio receivers, being used, for example, in the frequency changing stage of superheterodyne radio receivers to mix a received modulated radio frequency signal with an unmodulated locally generated signal to produce a modulated output signal of the frequency at which the intermediate frequency amplification stages of the receiver are designed to operate.

It is an object of the present invention to provide an electrical signal mixer circuit having a controllable gain.

According to the present invention there is provided an electrical signal mixer circuit comprising a signal transfer means connected in a path between an input to which a first signal to be mixed is applied in operation and an output at which the output of the mixer circuit appears in operation; and control means for cyclically changing the transfer function of said signal transfer means between first and second values at the frequency of a second signal to be mixed with said first signal, characterised in that said control means incorporates means for varying the fraction of the period of each cycle of change of said transfer function for which said transfer function has said first value.

In a preferred circuit according to the invention said signal transfer means comprises electronic switch means, and said control means operates said switch means between open and closed conditions to change said transfer function.

One mixer circuit in accordance with the invention will now be described, by way of example, with reference to the accompanying drawing in which:-

Figure 1 is a block schematic diagram of the mixer;

Figure 2 is a simplified equivalent circuit diagram of the mixer of Figure 1;

Figure 3 shows the circuit of one embodiment of part of the mixer of Figure 1; and

Figure 4 are waveforms illustrating the operation of the circuit of Figure 3.

The mixer is suitable for use in the frequency changer stage of a superheterodyne radio for converting a wanted received modulated radio frequency carrier wave signal to a correspondingly modulated intermediate frequency carrier wave signal.

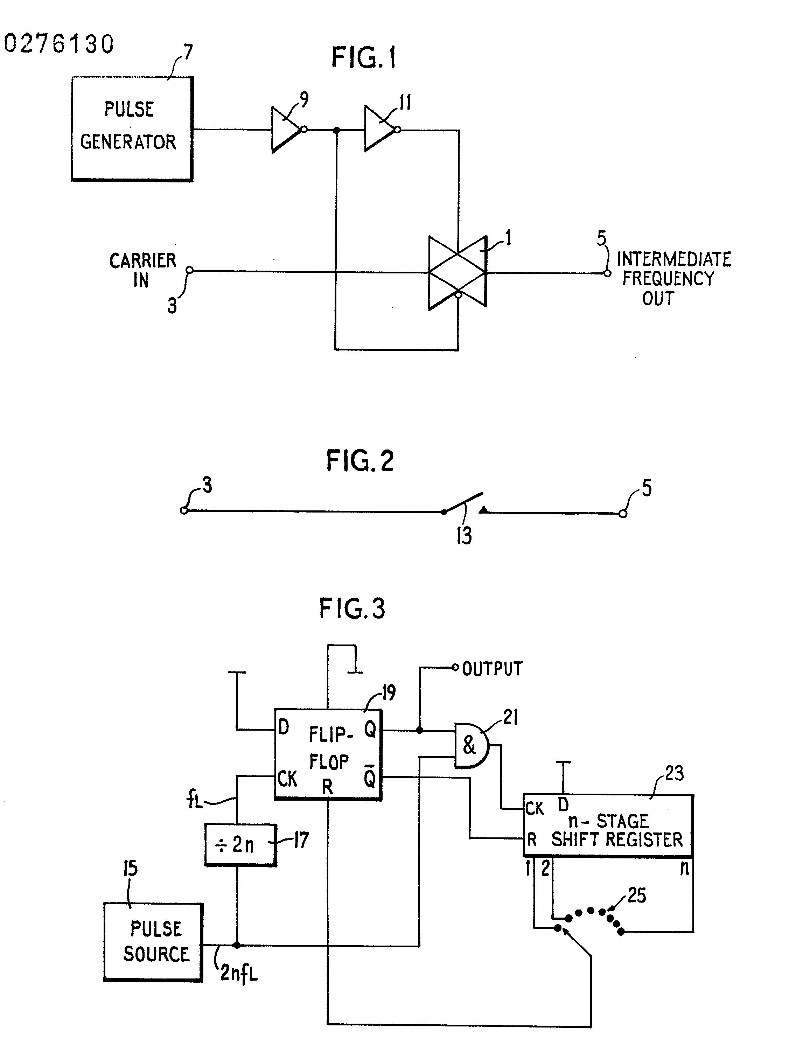

Referring to Figure 1, the mixer includes an electronic switch 1 comprising a CMOS semiconductor bilateral switch connected between an input terminal 3 to which the wanted modulated carrier wave signal is applied and a terminal 5 from which the intermediate frequency output of the mixer is derived.

The switch 1 is controlled by complementary pulse trains applied to opposite nodes of the switch 1, the two pulse trains being derived from a pulse generator 7 by way of two signal inverters 9 and 11.

In operation the switch 1 is alternately opened and closed by the applied pulse trains, and the mixer is thus equivalent to a switch 13 connected between the input and output terminals 3 and 5, and operated at the pulse train frequency, as illustrated in Figure 2.

As so far described, the mixer constitutes a known form of mixer circuit known as a switching mixer. In such known arrangements the output of the pulse generator 7, and hence the pulse trains applied to the switch 1, are of square waveform and so have components given by the expression:

$$\frac{4}{\pi} \sum_{n=1}^{n=\infty} \frac{\sin\,(2n-1)\,wt}{2n-1}$$

where $w$ is the angular frequency of the fundamental of the square waveform.

The output of the mixer consequently contains many different components each at a frequency equal to the product of the frequency of the carrier wave input of the mixer and a different multiple of the fundamental frequency of the square wave switching waveform.

When in use in a superheterodyne frequency changer, one such frequency component, normally a component having a frequency equal to the sum of, or the difference between, the frequency of the carrier wave and the fundamental frequency of the switching waveform, is selected by means of a filter (not shown) from the mixer output and used as the intermediate frequency signal.

In accordance with the invention the pulse generator 7 is arranged to provide a pulse train of desired frequency in which the duration of the pulses is controllable, i.e. the pulse train has a rectangular waveform of fixed frequency but variable duty cycle.

The frequency components of such a waveform are given by the expression:-

$$\frac{t_d}{T} + \frac{2t_d}{T} \sum_{n=1}^{n=\infty} \frac{\sin \frac{n \pi t_d}{T}}{\frac{n \pi t_d}{T}} \cos \frac{2n \pi t}{T}$$

where T is the period of the pulse train, and $t_d$ is the duration of the pulses in the pulse train.

It is apparent from this expression that the amplitude of each of the different frequency components in the output of the mixer, and hence of any particular component selected by filtering, is dependent on the ratio $t_d/T$ and that the gain of the mixer can thus be varied by variation of the value of this ratio.

A suitable arrangement of the pulse generator 7 of Figure 1 is illustrated in Figure 3.

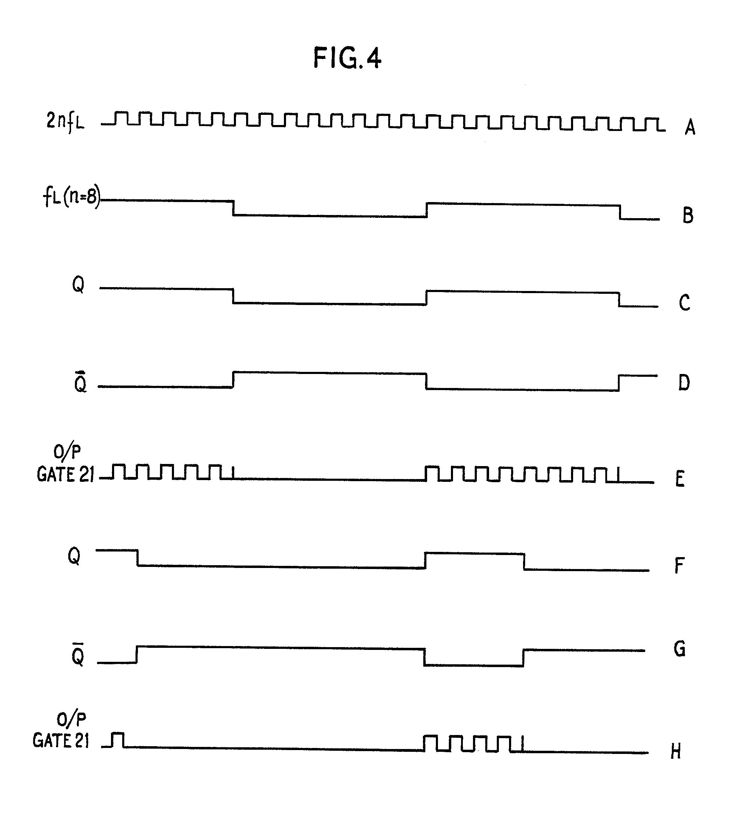

The arrangement includes a pulse source 15 which produces a square waveform pulse train of frequency $2nf_L$, as illustrated in Figure 4A. The output of the source 15 is applied via a divider 17 to the clock input CK of a D-type flip-flop 19, the divider being set to divide by 2n so that the clock input of the flip-flop 19 has a frequency $f_L$ (see Figure 4B).

The Q output of the flip-flop 19 is applied to one input of a two-input AND gate 21 whose other input is derived from the output of the pulse source 15.

The output of the AND gate 21 is applied to the clock input CK of an n-stage shift register 23. The Q output of the flip-flop 19 is applied to the reset input R of the shift register 23.

An n-position electronic switch 25 enables the output of any selected stage of the shift register 23 to be applied to the reset input R of the flip-flop 19.

An output for controlling the switch 1 via inverters 9 and 11 is derived from the Q output of the flip-flop 19.

The flip-flop 19 is arranged to set to a predetermined state in response to each positive-going edge at its clock input CK and the flip-flop 19 and shift register 23 are arranged to reset in response to each positive-going edge at their respective reset inputs.

In operation, in response to each positive-going edge in the signal applied to the clock input of the flip-flop 19, the Q output of the flip-flop assumes a high state. Thereafter, each output pulse of the pulse source 15 produces a corresponding pulse at the output of the AND gate 21 with a corresponding increase by one of the count in the shift register 23. When the count in the shift register 23 reaches a value corresponding to the setting of the switch 25, the flip-flop 19 is reset. Consequently the Q output of the flip-flop 19 changes to its high state, resetting the shift register 23, and the Q output of the flip-flop 19 changes to its low state closing the gate 21, and remains in this state until the next positive-going edge at the clock input of the flip-flop 19, whereupon the cycle is repeated.

Hence, referring to Figure 4, with n equal to eight and the switch 25 set to apply reset signals to the flip-flop 19, and hence the shift register 23, from the output of the eighth stage of the shift register 23, the Q output of the flip-flop 19 is in its high and low states for equal periods during each cycle of the signal at the output of the divider 17, as illustrated in Figures 4C, 4D and 4E which show respectively the waveforms at the Q and Q outputs of the flip-flop 19 and at the output of the AND gate 21.

With the switch 25 set to apply reset signals to the flip-flop 19, and hence to the shift register 23, from the output of the fourth stage of the shift register 23, the Q output is in its high state for 25% of the period of the signal at the output of the divider, as illustrated in Figures 4F, 4G and 4H.

Thus the Q output of the flip-flop 19 provides a pulse train of frequency $f_L$ for controlling the switch 1 in which the duration of the pulses is controllable by means of the switch 25 to have any one of n different values.

It will be understood that where the mixer is for use in a frequency changer, the frequency $f_L$ is the required local oscillator frequency, and may thus be arranged to be variable, variation being effected by changing the frequency of the pulse source 15 rather than the division factor of the divider 17.

One particular application of a mixer according to the invention is as a frequency changer in a superheterodyne radio receiver wherein the incoming wanted received carrier signal has such a wide dynamic range that automatic gain control applied to early stages of the receiver, e.g. the RF stages, cannot easily sufficiently limit the gain variation at subsequent stages. The invention allows automatic gain control to be additionally applied to the frequency changer to overcome this problem. One example of such a radio receiver is a radio receiver for the unattended reception of data which has been phase modulated onto a broadcast signal, as described, for example, in GB-2,060,953 B.

A further advantage of a mixer according to the invention is that it can conveniently be entirely fabricated in digital circuit form, and therefore lends itself to fabrication in semiconductor integrated circuit form. Thus a mixer circuit in accordance with the invention is very suitable for use in low cost radio receivers where as much of the circuitry as possible is fabricated in integrated circuit form. It will be appreciated in this connection that whilst in the embodiment of the invention described above by way of example the pulse generator 7 comprises discrete components, in other arrangements according to the invention, a microcomputer appropriately programmed may be used to generate the pulse train required to operate the switch 1.

## Claims

1. An electrical signal mixer circuit comprising a signal transfer means (1) connected in a path between an input (3) to which a first signal to be mixed is applied in operation and an output (5) at which the output of the mixer circuit appears in operation; and control means (7, 9, 11) for cyclically changing the transfer function of said signal transfer means (1) between first and second values at the frequency of a second signal to be mixed with said first signal; characterised in that said control means incorporates means (7) for varying the fraction of the period of each cycle of change of said transfer function for which said transfer function has said first value.

2. A circuit according to Claim 1 wherein signal transfer means (1) comprises electronic switch means (1), and said control (7) means operates said switch means (1) between open and closed conditions to change said transfer function.

3. A circuit according to Claim 1 wherein said control means comprises a digital circuit (15, 17, 19, 21, 23, 25).

4. A circuit according to Claim 3 wherein said digital circuit (15, 17, 19, 21, 23, 25) is constituted by a microcomputer.

5. A circuit according to Claim 3 wherein said digital circuit comprises: a source (15) which produces a pulse train of square waveform; a flip-flop circuit (19); means (17) for operating said flip-flop circuit from a first state into a second state in response to every 2nth pulse produced by said source; and means (21, 23, 25) for resetting said flip-flop circuit (19) into said first state in response to the xth pulse produced by said pulse source (15) following operation of said flip-flop circuit (19) into its second state, the value of $x$ being selectable from two or more values less than 2n.

6. A circuit according to Claim 5 wherein the value of $x$ is selectable from two or more values not greater than $n$.

7. A circuit according to Claim 5 or Claim 6 wherein said means for operating comprises a divide by 2n circuit (17) connected between said pulse source (15) and a clock input of said flip-flop circuit (19).

8. A circuit according to any one of Claims 5, 6 and 7 wherein said means for resetting comprises an AND-gate (21) having as inputs an output of said flip-flop circuit (19) and an output of said pulse source (15); a shift register (23) having as input the output of said AND-gate (21); and switch means (25) for applying the output of any selected one of two or more stages of said shift register (23) to a reset input of said flip-flop circuit (19).

9. A circuit according to Claim 8 wherein said shift register (23) has a reset input connected to an output of said flip-flop circuit (19).

10. A circuit according to any one of the preceding claims in a superheterodyne radio receiver and arranged to operate on a received signal as a frequency changer.

11. A circuit according to Claim 10 wherein said control means is arranged to vary said fraction so as to effect automatic gain control of the output of the receiver.

0276130

## FIG.1

## FIG.2

## FIG.3

0276130

## FIG.4